Europäisches Patentamt

European Patent Office

Office européen des brevets

(19)

(11) **EP 0 763 209 B1**

(12) **EUROPÄISCHE PATENTSCHRIFT**

(45) Veröffentlichungstag und Bekanntmachung des Hinweises auf die Patenterteilung:
**25.03.1998 Patentblatt 1998/13**

(21) Anmeldenummer: **95918534.9**

(22) Anmeldetag: **16.05.1995**

(51) Int Cl.[6]: **G01R 23/16**

(86) Internationale Anmeldenummer:
**PCT/DE95/00671**

(87) Internationale Veröffentlichungsnummer:
**WO 95/33211 (07.12.1995 Gazette 1995/52)**

(54) **VERFAHREN ZUM ERMITTELN VON HARMONISCHEN OBERSCHWINGUNGEN ZU EINER GRUNDSCHWINGUNG EINES ELEKTRISCHEN SIGNALS**

PROCESS FOR DETERMINING THE HARMONIC OSCILLATIONS OF THE FUNDAMENTAL COMPONENT OF AN ELECTRIC SIGNAL

PROCEDE DE DETERMINATION DES VIBRATIONS HARMONIQUES DE LA COMPOSANTE FONDAMENTALE D'UN SIGNAL ELECTRIQUE

(84) Benannte Vertragsstaaten:
**DE FR GB SE**

(30) Priorität: **01.06.1994 DE 4420348**

(43) Veröffentlichungstag der Anmeldung:
**19.03.1997 Patentblatt 1997/12**

(73) Patentinhaber: **SIEMENS AKTIENGESELLSCHAFT
80333 München (DE)**

(72) Erfinder:
 • **RECK, Thomas
  D-12247 Berlin (DE)**
 • **SEZI, Tevfik
  D-12169 Berlin (DE)**

(56) Entgegenhaltungen:
**US-A- 5 099 194**

 • **PATENT ABSTRACTS OF JAPAN vol. 012 no. 341,13.September 1988 & JP,A,63 101767 (TOSHIBA) 6.Mai 1988,**
 • **Elektronik, 2/23.1.1987, Seiten 89 bis 96**

**Beschreibung**

Die Erfindung bezieht sich auf ein Verfahren zum Ermitteln von harmonischen Oberschwingungen zu einer Grundschwingung eines elektrischen Signals, bei dem das Signal mit einer Abtastfrequenz abgetastet wird, die gleich einem Mehrfachen der Frequenz der Grundschwingung ist, und die abgetasteten Werte des Signals nach Analog-Digital-Umsetzung einer diskreten Fourier-Transformation (DFT) zum Ermitteln der harmonischen Oberschwingungen unterzogen werden.

Ein Verfahren dieser Art ist in der Zeitschrift "Elektronik" 2/23.1.1987, Seiten 89 bis 96, insbesondere Seiten 92 und 93 beschrieben. Bei diesem bekannten Verfahren erfolgt nach analoger Vorfilterung die Abtastung des elektrischen Signals mit einer Abtastrate, die einem ganzzahligen Mehrfachen der Frequenz einer Grundschwingung entspricht. Gemäß einem angegebenen Beispiel wird mit einer Abtastrate von 2,56 kHz abgetastet, und es werden neben einer Spektrallinie einer Grundschwingung von 160 Hz die Spektral-Linien bis zur sechsten harmonischen Oberschwingung erfaßt. Die Spektrallinien höherer Harmonischer liegen oberhalb der halben Abtastrate (Nyquist-Frequenz) und liefern bei reellen Eingangssignalen aufgrund einer Spiegelung an der Nyquist-Frequenz die gleichen Werte wie die ersten acht Spektrallinien. Die Spektrallinien der höheren Harmonischen können somit bei dem bekannten Verfahren bei einer Abtastfrequenz von 2,56 kHz nicht selektiert und erfaßt werden. Sollen auch diese Spektrallinien ermittelt werden, dann bedarf es bei dem bekannten Verfahren einer doppelt so hohen Abtastfrequenz, also einer Abtastfrequenz von 5,12 kHz.

Der Erfindung liegt die Aufgabe zugrunde, ein Verfahren zum Ermitteln von harmonischen Oberschwingungen zu einer Grundschwingung eines elektrischen Signals anzugeben, mit dem auch harmonische Oberschwingungen verhältnismäßig hoher Ordnung relativ einfach erfaßt werden können.

Zur Lösung dieser Aufgabe wird bei einem Verfahren der eingangs angegebenen Art erfindungsgemäß die Abtastung mit einer Abtastfrequenz durchgeführt, die gleich einem nichtganzzahligen Mehrfachen der Frequenz der Grundschwingung ist, und die diskrete Fourier-Transformation wird zur Erhöhung der Frequenzauflösung über mehrere Perioden der Grundschwingung zum Ermitteln der harmonischen Oberschwingungen vorgenommen.

Der Erfindung liegt die Erkenntnis zugrunde, daß sich bei einer Abtastung mit einem nichtganzzahligen Mehrfachen der Frequenz der Grundschwingung eine Spiegelung der harmonischen Oberschwingungen höherer Art an einer Nyquist-Frequenz ergibt, die nicht mit einer harmonischen Oberschwingung zusammenfällt, sondern zwischen zwei benachbarten harmonischen Oberschwingungen liegt. Dies führt dazu, daß die an einer solchen Nyquist-Frequenz gespiegelten harmonischen Oberschwingungen höherer Ordnung in "Lücken" zwischen den harmonischen Oberschwingungen niedriger Ordnung fallen und somit selektiert und gemessen werden können. Allerdings ist es dabei zur Gewinnung reproduzierbarer Meßergebnisse erforderlich, daß die diskrete Fourier-Transformation über einen mehrere Perioden der Grundschwingung ausmachenden Zeitraum durchgeführt wird.

Allgemein läßt sich feststellen, daß gemäß der Erfindung mit einer Abtastfrequenz $f_{ab}$ gearbeitet wird, die sich durch folgende Beziehung (1) beschreiben läßt

$$f_{ab} = N' \cdot f_{gr} \qquad [1]$$

In dieser Gleichung (1) bezeichnet $f_{gr}$ die Frequenz der Grundschwingung des zu untersuchenden elektrischen Signals. Die Größe N' läßt sich durch folgende Gleichung (2) beschreiben:

$$N' = M/L \qquad [2]$$

wobei M eine ganzzahlige ungerade Zahl und L $\geqq$ 1 und ganzzahlig ist. Wird beispielsweise für M=21 und für L=2 gewählt, dann bedeutet dies, daß gemäß der Erfindung mit einer Abtastfrequenz $f_{ab}$ gearbeitet wird, die das 10,5-fache der Grundfrequenz $f_{gr}$ ausmacht. In diesem Fall ist es erforderlich, eine diskrete Fourier-Transformation über L-Perioden durchzuführen, im vorliegenden Falle also über zwei Perioden.

Ein wesentlicher Vorteil des erfindungsgemäßen Verfahrens besteht darin, daß unter Benutzung einer relativ niedrigen Abtastfrequenz harmonische Oberschwingungen auch einer verhältnismäßig hohen Ordnung erfaßt werden können. Dadurch läßt sich der Aufwand bei der Messung der Harmonischen einer Grundschwingung in einem elektrischen Signal vermindern. Die verlängerte Meßzeit über mehrere Perioden der Grundschwingung kann häufig ohne weiteres in Kauf genommen werden, so daß dies in den meisten Anwendungsfällen nicht als problematisch anzusehen ist.

Häufig ist die Frequenz der Grundschwingung eines elektrischen Signals Schwankungen unterworfen; dies gilt beispielsweise für elektrische Signale, die aus dem Strom oder der Spannung eines elektrischen Energieversorgungsnetzes abgeleitet sind. Um auch bei derartigen elektrischen Signalen das erfindungsgemäße Verfahren unter Erzielung genauer Meßergebnisse anwenden zu können, wird gemäß einer Weiterbildung der Erfindung mit einer mit den abgetasteten Werten beaufschlagten Frequenz-Meßeinrichtung ein Meßwert ermittelt, der die momentane Frequenz der Grundschwingung des elektrischen Signals angibt; der Meßwert wird mit einem Faktor n zum Erzeugen eines abgeleiteten Meßwertes multipliziert, wobei n durch den Quotienten aus einer gewählten Abtastfrequenz und der Nennfrequenz der Grundschwingung des elektrischen Signals gegeben ist, und die Abtastung wird mit einer dem abgeleiteten Meßwert entsprechenden Abtastfrequenz durchgeführt.

Der wesentliche Vorteil dieser Ausführungsform des erfindungsgemäßen Verfahrens besteht darin, daß bei ihr unabhängig von der jeweiligen momentanen Frequenz des untersuchten analogen elektrischen Signals mit einer Abtastfrequenz gearbeitet wird, die dem n-fachen der momentanen Frequenz des elektrischen Signals entspricht. Dadurch ist die Meßgenauigkeit wesentlich erhöht, weil auch bei Frequenzen des elektrischen Signals, die von der Nennfrequenz abweichen, pro Periode des elektrischen Signals stets eine gleichgroße Anzahl von Abtastungen vorgenommen wird. Bei dieser Weiterbildung des erfindungsgemäßen Verfahrens wird also die Abtastfrequenz der jeweils ermittelten Frequenz der Grundschwingung des elektrischen Signals angepaßt.

Für sich ist diese Art der Anpassung der Abtastfrequenz an die Frequenz der Grundschwingung eines elektrischen Signals Gegenstand der nicht vorveröffentlichten älteren deutschen Offenlegungsschrift DE 43 30 179 A1.

Bei dem erfindungsgemäßen Verfahren kann der abgeleitete Meßwert in unterschiedlicher Weise dem Takteingang eines zur Analog-Digital-Umsetzung eingesetzten Analog-Digital-Wandlers zugeführt werden. Beispielsweise ist eine direkte Beaufschlagung möglich.

Im Hinblick auf eine möglichst hohe Genauigkeit wird es aber als vorteilhaft angesehen, wenn in einer weiteren Ausgestaltung des erfindungsgemäßen Verfahrens in einem Quotientenbildner eine den Quotienten aus der Höhe der Taktfrequenz eines Taktgenerators und dem abgeleiteten Meßwert angebende Zwischengröße gebildet wird und mit der Zwischengröße das Teilerverhältnis eines zwischen dem Taktgenerator und dem Takteingang eines zur Analog-Digital-Wandlung eingesetzten Analog-Digital-Wandlers angeordneten Frequenzteilers derart eingestellt wird, daß dem Takteingang die dem abgeleiteten Meßwert entsprechende Abtastfrequenz zugeführt wird. Es ist somit sichergestellt, daß die Abtastfrequenz stets neu aus der Taktfrequenz des Taktgenerators abgeleitet wird.

Um ein stabil arbeitendes Verfahren nach der Erfindung zu erreichen, ist es vorteilhaft, wenn eine Änderung des Teilerverhaltnisses jeweils frühestens nach Ablauf einiger Perioden des elektrischen Signals vorgenommen wird.

Bei dem erfindungsgemäßen Verfahren ist wegen der erzielbaren hohen Genauigkeit der Frequenz-Messung vorteilhafterweise die Frequenz-Meßeinrichtung eine digitale Frequenz-Meßeinrichtung.

Zur Erläuterung der Erfindung ist in

Figur 1 ein Diagramm zur weiteren Erläuterung des oben angegebenen bekannten Verfahrens, in
Figur 2 ein weiteres Diagramm zur Erklärung des erfindungsgenaßen Verfahrens, in
Figur 3 eine Tabelle zur Erläuterung der Spiegelung der Harmonischen ins Basisband und in
Figur 4 eine Anordnung zur Durchführung des erfindungsgemäßen Verfahrens in Form eines Blockschaltbildes wiedergegeben.

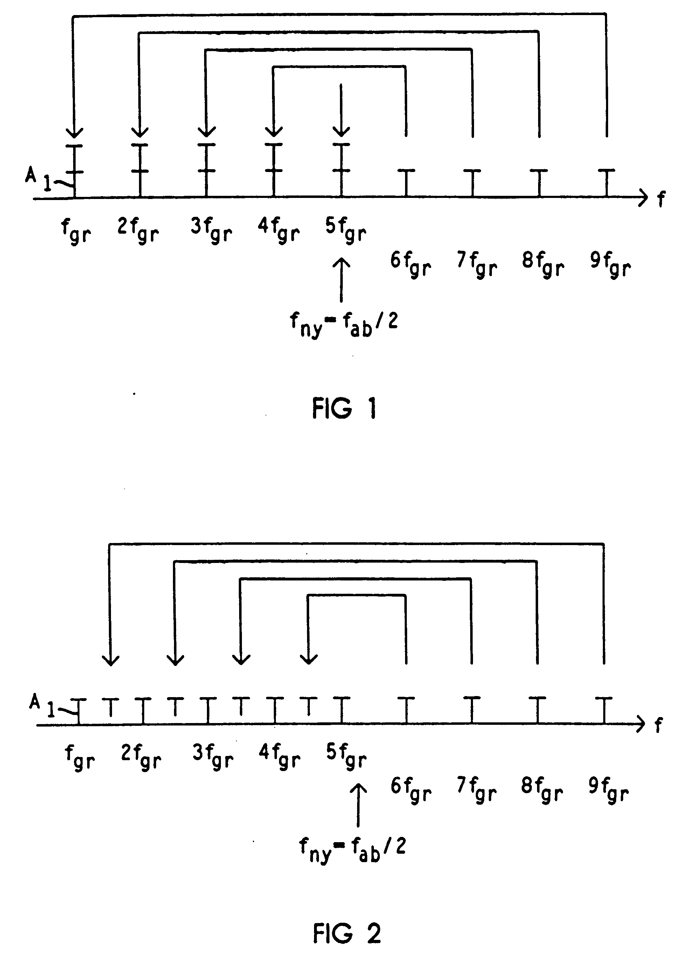

In Figur 1 sind über der Frequenz die Spektrallinien einer Grundfrequenz $f_{gr}$ mit dem Wert $A_1$ sowie harmonischer Oberschwingungen $2f_{gr}$ bis $5f_{gr}$ aufgetragen, wobei der Einfachheit halber angenommen ist, daß die Werte der harmonischen Oberschwingungen ebenfalls $A_1$ betragen. Es ist ferner in Figur 1 angegeben, daß mit einer Abtastfrequenz $f_{ab}$ gearbeitet wird, die der doppelten Frequenz der vierten harmonischen Oberschwingung $5f_{gr}$ entspricht; die vierte harmonische Oberschwingung ist also die Nyquist-Frequenz $f_{ny}$. Es erfolgt dann bei dem bekannten Verfahren eine Spiegelung der fünften bis achten harmonischen Oberschwingungen ($6f_{gr}$ bis $9f_{gr}$) an der Nyquist-Frequenz $f_{ny}$, wie dies durch die mit Pfeilen versehenen Linien in Figur 1 angegeben ist. Dies bedeutet, daß bei den Frequenzen $f_{gr}$ bis $5f_{gr}$ Spektrallinien mit einem Amplitudenwert von $2 \cdot A_1$ erfaßt werden, wenn man einmal unterstellt, daß die harmonischen Oberschwingungen $6f_{gr}$ bis $9f_{gr}$ dieselben Amplitudenwerte $A_1$ aufweisen wie die Harmonischen $f_{gr}$ bis $5f_{gr}$. Die Darstellung gemäß Figur 1 zeigt also deutlich, daß bei dem bekannten Verfahren mit einer Abtastfrequenz, die der doppelten Nyquist-Frequenz $f_{ny}$ entspricht, nur die Oberschwingungen bis zur fünften Harmonischen erfaßt werden können.

In Figur 2 sind wiederum über der Frequenz f die Spektrallinien der Grundschwingungen $f_{gr}$ bis zur vierten Oberschwingung $5f_{gr}$ aufgetragen; es ist nunmehr angenommen, daß mit einer Abtastfrequenz $f_{ab}$ gearbeitet wird, die sich durch folgende Beziehung (3) beschreiben läßt:

$$f_{ab} = N' \cdot f_{gr} \, ,$$

wobei $N' = 10{,}5$ gewählt ist. Die Nyquist-Frequenz liegt jetzt bei $5{,}25 \cdot f_{gr}$, so daß eine Spiegelung der höheren harmonischen Oberschwingungen an dieser Frequenz erfolgt mit dem Ergebnis, daß die sechsten bis neunten Harmonischen genau in die Mitte zwischen den harmonischen Oberschwingungen niedrigerer Ordnung fallen; damit ist eine Erfassung auch bis zur neunten Harmonischen $9f_{gr}$ möglich, obwohl nur mit einer dem $10{,}5$-fachen der Grundschwingungsfrequenz entsprechenden Frequenz abgetastet wird.

Für die Bestimmung der Spektrallinien mittels der diskreten Fourier-Transformation ist über eine Zeitdauer zu ermitteln, die zwei Perioden der Grundschwingung beträgt. Erst dann ist sichergestellt, daß das Meßergebnis unabhängig vom jeweiligen ersten Abtastzeitpunkt im Hinblick auf den Zeitverlauf der Grundschwingung gemessen werden kann. Dementsprechend ist für den Fall, daß beispielsweise N' = 10,33 gewählt wird, die Erfassung mittels der diskreten Fourier-Transformation über drei Grundschwingungen durchzuführen, um alle Spektralkomponenten genau zu erfassen.

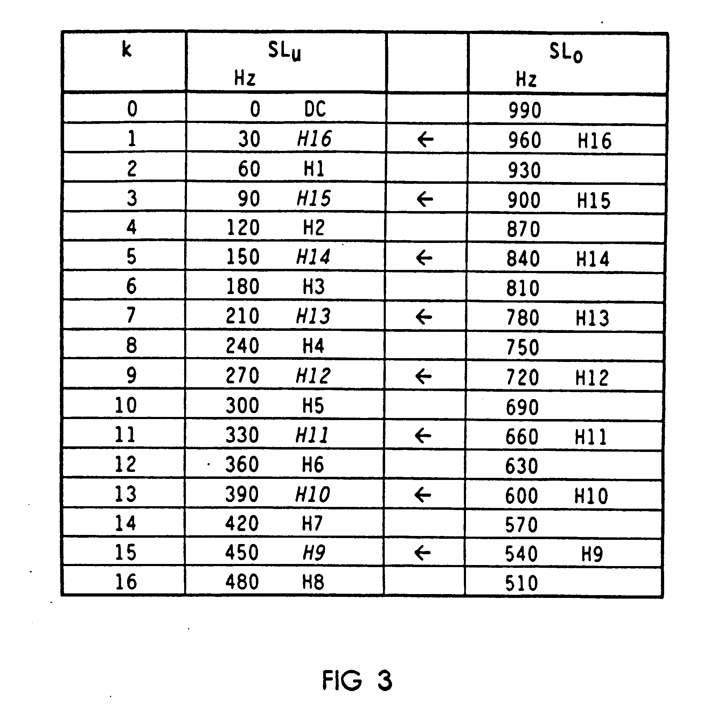

Wird beispielsweise das erfindungsgemäße Verfahren zum Ermitteln von harmonischen Oberschwingungen eines elektrischen Signals angewendet, das aus einem Strom oder einer Spannung in einem elektrischen Energieversorgungsnetz mit 60 Hz abgeleitet ist, dann ergeben sich bei einer Abtastfrequenz, die dem 16,5-fachen der Netzfrequenz von 60 Hz entspricht, die in Figur 3 dargestellten Verhältnisse. Dabei gibt die mit "k" überschriebene, linke Spalte jeweils die Komponente der diskreten Fourier-Transformation an, während in Spalte 2 die Spektrallinien SLu unterhalb der Nyquist-Frequenz einmal in Hz und daneben als Bezeichnung der jeweiligen Harmonischen aufgeführt sind. "DC" steht dabei für ein Gleichstromglied, "H16" für die 16. Harmonische, also die 15. Oberwelle, "H1" für die Grundschwingung von 60 Hz, usw. In der ganz rechten Spalte der Figur 3 sind Spektrallinien $SL_o$ aufgeführt, die im Frequenzband oberhalb der Nyquist-Frequenz von 495 Hz liegen. Die Pfeile in einer weiteren Spalte sollen verdeutlichen, daß eine Spiegelung der jeweils in der rechts davon aufgeführten Spalte angegebenen Spektrallinien $SL_o$ an der Nyquist-Frequenz auftritt. Die jeweils kursiv in der Spalte $SL_u$ eingetragenen Bezeichnungen sollen die durch Spiegelung an der Nyquist-Frequenz auftretenden Spektrallinien kennzeichnen. Die Figur 3 läßt deutlich erkennen, daß trotz einer Abtastfrequenz von nur 990 Hz Spektrallinien bis zur 16. Harmonischen H16, also bis 960 Hz mit dem erfindungsgemäßen Verfahren erfaßt werden können.

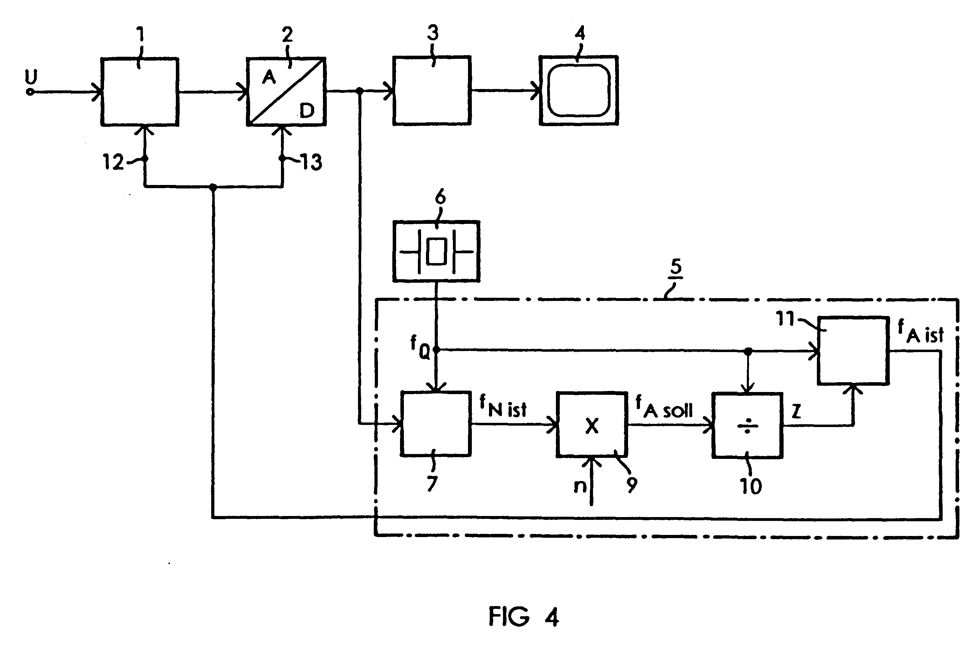

Gemäß Figur 4 wird ein zu untersuchendes elektrisches Signal U mittels einer Abtasteinrichtung 1 mit einer Abtastfrequenz abgetastet, die im Hinblick auf die obigen Ausführungen gewählt ist. Die abgetasteten Werte werden in einem Analog-Digital-Umsetzer 2 in digitale Werte umgesetzt, die in einer nachgeordneten Datenverarbeitungsanlage 3 einer diskreten Fourier-Transformation unterzogen werden. Beispielsweise auf einem Monitor 4 können dann die Spektrallinien entsprechend der Darstellung nach Figur 2 angezeigt werden; selbstverständlich ist auch ein Ausdruck der Spektrallinien mittels eines geeigneten Peripherie-Gerätes möglich.

Um auch harmonische Oberschwingungen in einem elektrischen Signal U mit schwankender Frequenz seiner Grundschwingung genau erfassen zu können, ist die Anordnung mit den Bausteinen 1 bis 4 gemäß Fig. 4 durch einen Abtastsignal-Geber 5 und einen Taktgenerator 6 ergänzt. Der Abtastsignal-Geber 5 weist eingangsseitig eine digitale Frequenz-Meßeinrichtung 7 auf, die beispielsweise so ausgeführt sein kann und so arbeiten kann, wie es in dem Aufsatz von J. Heydeman und E.N. Luf "Microprozessor Based Underfrequency Relaying", Delft University of Technology, the Netherlands, veröffentlicht in IEEE Conference Publication No.

249, Third Internal Conference on Developments in Power-System Protection, 1985, Seiten 24 bis 28, im einzelnen beschrieben ist. Bevorzugt wird als Frequenz-Meßeinrichtung jedoch eine Anordnung, wie sie in der nicht vorveröffentlichten älteren deutschen Patentschrift DE 42 11 946 C1 oder der korrespondierenden internationalen Anmeldung WO 93/20454 erläutert ist. Der digitalen Frequenz-Meßeinrichtung 7 ist der Taktgeber 6 zugeordnet, der eine Taktfrequenz $f_Q$ an die digitale Frequenz-Meßeinrichtung 7 abgibt. Am Ausgang der digitalen Frequenz-Meßeinrichtung 7 ergibt sich dann ein Meßwert $f_{Nist}$, der die momentane Frequenz des Signals U angibt.

Der Meßwert $f_{Nist}$ wird einem Multiplizierer 9 zugeführt, in dem eine Multiplikation mit einem Faktor n erfolgt. Dieser Faktor n gibt das Verhältnis einer gewählten Abtastfrequenz $f_A$ zur Nennfrequenz der Grundschwingung des analogen elektrischen Signals U an. Bei einer Spannung in einem elektrischen Energieversorgungsnetz als analoges elektrisches Signal U beträgt die Nennfrequenz beispielsweise 60 Hz; sie entspricht der Nennfrequenz. Die Abtastfrequenz $f_A$ ist beispielsweise zu 990 Hz gewählt, so daß der Faktor n den Wert 16,5 aufweist.

Am Ausgang des Multiplizierers 9 entsteht ein abgeleiteter Meßwert $f_{Asoll}$, der eine Abtast-Sollfrequenz angibt; bei dem oben gewählten Zahlenbeispiel beträgt diese Frequenz in dem Falle, in dem die Spannung U die Frequenz von genau 60 Hz hat, also 990 Hz. Ist dagegen die momentane Frequenz am Ausgang der digitalen Frequenz-Meßeinrichtung z.B. zu 59,5 Hz ermittelt, beträgt also der Meßwert $f_{Nist}$ = 59,5 Hz, dann wird eine Abtast-Sollfrequenz von 981,75 Hz errechnet, weil der abgeleitete Meßwert $f_{Asoll} = n \cdot f_{Nist}$. Der abgeleitete Meßwert $f_{Asoll}$ wird einem nachgeordneten Quotientenbildner 10 zugeführt, der auch noch mit der Taktfrequenz $f_Q$ des Taktgenerators 6 beaufschlagt ist. Am Ausgang des Quotientenbildners 10 entsteht dann eine Zwischengröße Z, die sich durch folgende Beziehung beschrieben läßt,

$$f_Q / f_{Asoll} = Z$$

Mit dieser Zwischengröße Z wird das Teilverhältnis eines nachgeordneten Frequenzteilers 11 verändert, der mit einem weiteren Eingang unmittelbar mit dem Taktgenerator 6 verbunden ist. Am Ausgang des Frequenzteilers 11 entsteht somit ein Signal mit einer Frequenz $f_{Aist}$, die sich durch folgende Gleichung beschreiben läßt

$$f_{Aist} = f_Q \cdot (f_{Asoll} / f_Q)$$

Die Frequenz $F_{Aist}$ entspricht daher der Abtast-Sollfrequenz, wodurch sichergestellt ist, daß der Analog-Digital-Wandler 2 stets mit einer solchen Frequenz $f_{Aist}$ getaktet wird, die genau dem n-fachen der jeweiligen momentanen Frequenz des elektrischen Signals U entspricht. Der Ausgang des Frequenzteilers 11 ist nämlich mit den Takteingängen 12 und 13 der Abtasteinrichtung 1 und des Analog-Digital-Wandlers 2 verbunden.

Um die Arbeitsweise des dargestellten Verfahrens stabil zu halten, wird die Beaufschlagung des Analog-Digital-Wandlers 2 mit jeweils einer neu angepaßten Abtastfrequenz nicht sofort auf eine Änderung des Meßwertes $f_{Nist}$ hin vorgenommen, sondern es wird in nicht dargestellter Weise eine Verzögerung durchgeführt, die beispielsweise in der Größenordnung von 4 Perioden des elektrischen Signals U liegen kann. Erst nach Ablauf von 4 Perioden des Signals U wirkt sich also eine Änderung des Meßwertes $f_{Nist}$ auf die Abtastfrequenz $f_{Aist}$ aus.

**Patentansprüche**

1. Verfahren zum Ermitteln von harmonischen Oberschwingungen zu einer Grundschwingung eines elektrischen Signals (U), bei dem

   - das Signal mit einer Abtastfrequenz abgetastet wird, die gleich einem Mehrfachen der Frequenz ($f_{gr}$) der Grundschwingung ist, und
   - die abgetasteten Werte des Signals nach Analog-Digital-Umsetzung einer diskreten Fourier-Transformation (DFT) zum Ermitteln der harmonischen Oberschwingungen unterzogen werden,

   **dadurch gekennzeichnet**, daß

   - die Abtastung mit einer Abtastfrequenz ($f_{ab}$) durchgeführt wird, die gleich einem nichtganzzahligen Mehrfachen (N') der Frequenz ($f_{gr}$) der Grundschwingung ist, und
   - die diskrete Fourier-Transformation zur Erhöhung der Frequenzauflösung über mehrere Perioden der Grundschwingung zum Ermitteln der harmonischen Oberschwingungen (H2 bis H16) vorgenommen wird.

2. Verfahren nach Anspruch 1,
   **dadurch gekennzeichnet**, daß

   - mit einer mit den abgetasteten Werten beaufschlagten Frequenz-Meßeinrichtung (7) ein Meßwert ($f_{Nist}$) ermittelt wird, der die momentane Frequenz der Grundschwingung des elektrischen Signals (U) angibt,
   - der Meßwert ($f_{Nist}$) mit einem Faktor n zum Erzeugen eines abgeleiteten Meßwertes ($f_{Asoll}$) multipliziert wird, wobei

      - n durch den Quotienten aus einer gewählten Abtastfrequenz ($f_A$) und der Nennfrequenz der Grundschwingung des elektrischen Signals (U) gegeben ist, und

   - die Abtastung mit einer dem abgeleiteten Meßwert ($f_{Asoll}$) entsprechenden Abtastfrequenz ($f_{Aist}$) durchgeführt wird.

3. Verfahren nach Anspruch 2,
   **dadurch gekennzeichnet**, daß

   - in einem Quotientenbildner (10) eine den Quotienten aus der Höhe der Taktfrequenz ($f_Q$) eines Taktgenerators (6) und dem abgeleiteten Meßwert ($f_{Asoll}$) angebende Zwischengröße (Z) gebildet wird und
   - mit der Zwischengröße (Z) das Teilerverhältnis eines zwischen dem Taktgenerator (6) und dem Takteingang (13) eines zur Analog-Digital-Wandlung eingesetzten Analog-Digital-Wandlers (2) angeordneten Frequenzteilers (11) derart eingestellt wird, daß dem Takteingang (13) die dem abgeleiteten Meßwert ($f_{Asoll}$) entsprechende Abtastfrequenz ($f_{Aist}$) zugeführt wird.

4. Verfahren nach Anspruch 3,
   **dadurch gekennzeichnet**, daß

   - eine Änderung des Teilerverhältnisses jeweils frühestens nach Ablauf einiger Perioden des elektrischen Signals (U) vorgenommen wird.

5. Verfahren nach einem der Ansprüche 2 bis 4,
   **dadurch gekennzeichnet**, daß

   - die Frequenz-Meßeinrichtung (7) eine digitale Frequenz-Meßeinrichtung ist.

**Claims**

1. Method for establishing harmonic oscillations for a fundamental oscillation of an electrical signal (U), in which method

   - the signal is sampled with a sampling frequency which is equal to a multiple of the frequency ($f_{gr}$) of the fundamental oscillation, and
   - after analog-to-digital conversion, the sampled values of the signal are subjected to a discrete Fourier transformation (DFT) in order to establish the harmonic oscillations,

   characterised in that

   - the sampling is carried out with a sampling frequency ($f_{ab}$) which is equal to a non-integral multiple (N') of the frequency ($f_{gr}$) of the fundamental oscillation, and

- in order to raise the frequency resolution, the discrete Fourier transformation is carried out over several periods of the fundamental oscillation in order to establish the harmonic oscillations (H2 to H16).

**2.** Method according to claim 1, characterised in that

- using a frequency measuring device (7) to which the sampled values are applied, a measured value ($f_{Nist}$) which indicates the instantaneous frequency of the fundamental oscillation of the electrical signal (U) is established,
- the measured value ($f_{Nist}$) is multiplied by a factor n in order to generate a derived measured value ($f_{Asoll}$), with

  - n being given by the quotient of a selected sampling frequency ($f_A$) and the rated frequency of the fundamental oscillation of the electrical signal (U), and

- the sampling is carried out with a sampling frequency ($f_{Aist}$) which corresponds to the derived measured value ($f_{Asoll}$).

**3.** Method according to claim 2, characterised in that

- there is formed in a quotient former (10) an intermediate variable (Z) which indicates the quotient of the level of the clock frequency ($f_Q$) of a clock generator (6) and the derived measured value ($f_{Asoll}$), and
- using the intermediate variable (Z), the divider ratio of a frequency divider (11), which is arranged between the clock generator (6) and the clock input (13) of an analog-to-digital converter (2) used for the analog-to-digital conversion, is adjusted in such a way that the sampling frequency ($f_{Aist}$) which corresponds to the derived measured value ($f_{Asoll}$) is supplied to the clock input (13).

**4.** Method according to claim 3, characterised in that an alteration of the divider ratio is carried out in each case at the earliest after the end of several periods of the electrical signal (U).

**5.** Method according to one of the claims 2 to 4, characterised in that the frequency measuring device (7) is a digital frequency measuring device.

**Revendications**

**1.** Procédé de détermination d'oscillations harmoniques d'une composante fondamentale d'un signal électrique (U), selon lequel

- le signal est balayé avec une fréquence de balayage qui est égale à un multiple de la fréquence ($f_{gr}$) de la composante fondamentale, et
- les valeurs détectées du signal sont soumises après conversion analogique/numérique à une transformation discrète de Fourier (TDF) pour la détermination des oscillations harmoniques,

caractérisé par le fait que

- le balayage est effectué avec une fréquence de balayage ($f_{ab}$) qui est égale à un multiple non-entier (N') de la fréquence ($f_{gr}$) de la composante fondamentale, et
- pour augmenter la résolution de la fréquence, la transformation discrète de Fourier est effectuée sur plusieurs périodes de la composante fondamentale pour déterminer les oscillations harmoniques (H2 à H16).

**2.** Procédé selon la revendication 1, caractérisé par le fait que

- une valeur de mesure ($f_{Nist}$) est déterminée avec un dispositif (7) de mesure de fréquence alimenté par les valeurs détectées, laquelle indique la fréquence instantanée de la composante fondamentale du signal électrique (U),
- la valeur de mesure ($f_{Nist}$) est multipliée par un facteur n afin de générer une valeur de mesure dérivée ($f_{Asoll}$),

  - n étant donné par le quotient d'une fréquence de balayage ($f_A$) choisie et de la fréquence nominale de la composante fondamentale du signal électrique (U), et

- le balayage est effectué avec une fréquence de balayage ($f_{Aist}$) correspondant à la valeur de mesure dérivée ($f_{Asoll}$).

**3.** Procédé selon la revendication 2, caractérisé par le fait

- qu'il est formé, dans un dispositif (10) de formation de quotient, une grandeur intermédiaire (Z), qui indique le quotient de la hauteur de la fréquence d'impulsion ($f_Q$) d'un générateur d'impulsions (6) et de la valeur de mesure dérivée ($f_{Asoll}$), et
- que le rapport de division d'un diviseur de fréquence (11) disposé entre le générateur d'impulsions (6) et l'entrée d'impulsion (13) d'un convertisseur analogique/numérique (2) utilisé pour la conversion analogique/numérique est réglé avec la grandeur intermédiaire (Z), de telle sorte que la fréquence de balayage ($f_{Aist}$) correspondant à la valeur de mesure dérivée ($f_{Asoll}$) soit transmise à l'entrée d'impulsion (13).

4.  Procédé selon la revendication 3, caractérisé par le fait

    -   qu'une modification du rapport de division est à chaque fois effectuée au plus tôt à l'issue de quelques périodes du signal électrique (U).

5.  Procédé selon l'une des revendications 2 à 4, caractérisé par le fait que

    -   le dispositif (7) de mesure de fréquence est un dispositif de mesure numérique de fréquence.

$f_{gr}$ $\quad$ $2f_{gr}$ $\quad$ $3f_{gr}$ $\quad$ $4f_{gr}$ $\quad$ $5f_{gr}$

$6f_{gr}$ $\quad$ $7f_{gr}$ $\quad$ $8f_{gr}$ $\quad$ $9f_{gr}$

$f_{ny} = f_{ab}/2$

## FIG 1

$f_{gr}$ $\quad$ $2f_{gr}$ $\quad$ $3f_{gr}$ $\quad$ $4f_{gr}$ $\quad$ $5f_{gr}$

$6f_{gr}$ $\quad$ $7f_{gr}$ $\quad$ $8f_{gr}$ $\quad$ $9f_{gr}$

$f_{ny} = f_{ab}/2$

## FIG 2

| k | SL$_u$ | | | SL$_o$ | |
|---|---|---|---|---|---|
| | Hz | | | Hz | |
| 0 | 0 | DC | | 990 | |
| 1 | 30 | *H16* | ← | 960 | H16 |
| 2 | 60 | H1 | | 930 | |
| 3 | 90 | *H15* | ← | 900 | H15 |
| 4 | 120 | H2 | | 870 | |
| 5 | 150 | *H14* | ← | 840 | H14 |
| 6 | 180 | H3 | | 810 | |
| 7 | 210 | *H13* | ← | 780 | H13 |
| 8 | 240 | H4 | | 750 | |
| 9 | 270 | *H12* | ← | 720 | H12 |
| 10 | 300 | H5 | | 690 | |
| 11 | 330 | *H11* | ← | 660 | H11 |
| 12 | 360 | H6 | | 630 | |
| 13 | 390 | *H10* | ← | 600 | H10 |
| 14 | 420 | H7 | | 570 | |
| 15 | 450 | *H9* | ← | 540 | H9 |
| 16 | 480 | H8 | | 510 | |

## FIG 3

U

1  2  A / D  3  4

12  13

6

5

$f_Q$

11  $f_{A\,ist}$

$f_{N\,ist}$  X  $f_{A\,soll}$  ÷  Z

7  n  9  10

FIG 4